# FASCICULE DE BREVET EUROPEEN

(11) **EP 0 994 503 B1**
(45) Date de publication et mention de la délivrance du brevet: **24.08.2016**
(21) Numéro de dépôt: 99402531.0
(22) Date de dépôt: 14.10.1999
(51) Int. Cl.: H01L 21/20, H01L 21/762

(54) **Procédé de fabrication d'une structure comportant une couche mince de matériau composée de zones conductrices et de zones isolantes**
Verfahren zur Herstellung einer Struktur mit einer dünnen Schicht aus einem aus elektrisch leitfähigen und isolierenden Zonen zusammengesetztem Material
Process for manufacturing a structure comprising a thin layer composed of material containing conductive and isolation regions

(30) Priorité: 16.10.1998 FR 9813010
(43) Date de publication de la demande: 19.04.2000
(73) Titulaire: Commissariat à l'Énergie Atomique et aux Énergies Alternatives, 75015 Paris (FR)
(72) Inventeur: Aspar, Bernard, 38140 Rives (FR); Bruel, Michel, 38113 Veurey (FR); Jalaguier, Eric, 38410 Saint Martin d'Uriage (FR)
(74) Mandataire: Audier, Philippe André

(56) Documents cités:
- EP-A1- 0 660 140
- FR-A- 2 758 907
- US-A- 5 256 581
- US-A- 5 783 477
- "SOI INTERPOSER STRUCTURE" IBM TECHNICAL DISCLOSURE BULLETIN, vol. 39, no. 7, 1 juillet 1996 (1996-07-01), pages 191-195, XP000627972
- HIROSHI WADA ET AL: "ELECTRICAL CHARACTERISTICS OF DIRECTLY-BONDED GAAS AND INP" APPLIED PHYSICS LETTERS, vol. 62, no. 7, 15 février 1993 (1993-02-15), pages 738-740, XP000338292

## Description

### Domaine technique

La présente invention concerne une structure comportant une couche mince de matériau composée de zones conductrices et de zones isolantes. Elle concerne aussi le procédé de fabrication d'une telle structure.

### Etat de la technique antérieure

Certains composants réalisés sur la surface d'un substrat nécessitent, pour leur utilisation, qu'un courant électrique puisse circuler dans l'épaisseur du substrat, c'est-à-dire dans le sens vertical par rapport au plan du substrat. On peut citer comme exemple de composants à fonctionnement vertical : les diodes électroluminescentes, les diodes lasers (en particulier les diodes lasers à cavité verticale), les photodétecteurs, les détecteurs hyperfréquences (en particulier les diodes Schottky), les composants de puissance, les cellules solaires. Ces composants se présentent schématiquement sous la forme de substrats dopés sur lesquels sont fabriquées les couches actives et non actives avec un dopage déterminé. En règle générale, les contacts électriques sont pris sur la surface en face avant et à l'arrière du composant ou en profondeur.

Les diodes de puissance présentent deux contacts : le contact d'anode sur la face avant et le contact de cathode sur la face arrière. Pour des composants de puissance plus sophistiqués tels que les MOSFET, les IGBT et les structures thyristor, on retrouve toujours un contact en face avant et un contact en face arrière avec une ou plusieurs prises de contact en profondeur. Cependant, pour tous ces types de composants, le courant électrique circule entre les faces avant et arrière du dispositif (voir par exemple l'article de synthèse intitulé "Trends in power semiconductor devices" de B. JAYANT BALIGA, paru dans IEEE Transactions on Electron Devices, Vol. 43, n° 10, octobre 1996).

L'une des techniques pour obtenir les couches actives sur le substrat est la croissance épitaxiale. Cette technique consiste à faire croître un matériau de manière ordonnée à partir d'un substrat cristallin tout en maîtrisant sa composition. On peut ainsi réaliser des empilements de couches épitaxiées semiconductrices de dopage variable. Si les couches semiconductrices épitaxiées sont de même nature que le substrat cristallin, on parle de dépôt par homo-épitaxie. Si elles sont de nature différente, on est en présence de dépôt par hétéro-épitaxie. Cette technique permet de réaliser des couches semiconductrices de très faible épaisseur (quelques dizaines d'angströms), de grande pureté et avec des interfaces d'excellente qualité. Néanmoins, cette technique est très coûteuse et sa faible vitesse de dépôt ne permet pas d'obtenir d'une manière industrielle des couches semiconductrices d'épaisseur supérieure à quelques dizaines de micromètres. De plus, l'épitaxie des couches ne peut être réalisée que si le substrat possède des paramètres cristallins qui soient proches de ceux du matériau à épitaxier. En effet, si les paramètres cristallins ne sont pas assez proches, une contrainte d'adaptation des paramètres de maille diminue fortement les bonnes propriétés optiques et électroniques des structures obtenues par hétéro-épitaxie. Cela limite donc sévèrement le nombre et la diversité des couches que l'on peut faire croître. En particulier, on peut citer la difficulté d'obtenir des composants de la famille des semiconducteurs III-V sur des substrats de silicium. Or, pour certains composants, il est intéressant d'allier les avantages de différents semiconducteurs. A titre d'exemple, on peut considérer les cas d'une couche active de GaAs ou d'une couche active d'InP sur du silicium. Cette configuration permet d'associer les bonnes propriétés électroniques des matériaux GaAs ou InP en hyperfréquence avec un substrat de silicium qui a l'avantage d'être plus robuste, d'avoir un poids plus faible et qui possède une bien meilleure conductivité thermique que le GaAs. On peut citer également le cas d'une couche de GaN sur un substrat de SiC, structure qui offre de multiples avantages pour des composants d'électronique de puissance.

Dans un autre domaine, les cellules solaires pour le spatial présentent un intérêt important. En effet, l'alimentation en énergie des satellites est généralement réalisée au moyen de panneaux de cellules solaires. Parmi les différentes possibilités de réalisation des cellules solaires pour le domaine spatial, on peut citer les cellules solaires réalisées en GaAs. Le problème de l'arséniure de gallium est son coût et surtout son poids et sa fragilité. Pour résoudre ce problème, il a été proposé de réaliser des cellules solaires à partir de films minces de GaAs épitaxiés sur un substrat de germanium. Une amélioration importante consisterait à obtenir des couches minces de GaAs ou d'InP sur un substrat de silicium. Ce type de structure permet de combiner les avantages du GaAs (propriétés de surface pour réaliser le composant constituant la cellule solaire) et les avantages du silicium en tant que support (poids trois fois moindre que celui du GaAs et fragilité moins importante).

Pour réaliser ces structures constituées d'un film mince solidaire d'un substrat en matériau différent, d'autres procédés que l'hétéro-épitaxie peuvent être utilisés. On peut citer en particulier les méthodes de mise en contact de substrats semiconducteurs par collage par adhésion moléculaire ou les techniques de report de films minces. Le procédé divulgué par le document FR-A-2 681 472 présente de nombreux atouts. Il permet le transfert d'un film mince (de quelques milliers d'angströms à quelques micromètres d'épaisseur), semiconducteur et de grande surface, depuis son substrat d'origine vers le support désiré par la combinaison d'une implantation ionique (au moyen d'ions légers), d'un collage par adhésion moléculaire et d'un traitement thermique adéquat.

Cette technique de transfert a fait l'objet d'autres développements. Selon le document FR-A-2 748 851, l'étape d'implantation ionique est conduite avec une dose d'ions comprise entre une dose minimum et une dose maximum, la dose minimum étant celle à partir de laquelle il y aura une création suffisante de microcavités pour obtenir la fragilisation du substrat suivant le plan de référence, la dose maximum, ou dose critique, étant celle au-dessus de laquelle, pendant l'étape de traitement thermique, il y a séparation du substrat. L'étape de séparation comporte l'application de forces mécaniques entre les deux parties du substrat.

Si le film mince délimité dans le substrat est suffisamment rigide par lui-même (à cause de son épaisseur ou à cause de ses propriétés mécaniques) on peut obtenir, après le recuit de transfert, un film autoporté. C'est ce qu'enseigne le document FR-A-2 738 671.

Le document FR-A-2 767 416 divulgue qu'il est possible de baisser la température de recuit si l'on tient compte du budget thermique fourni au substrat au cours des différentes étapes du procédé (étape d'implantation ionique, étape éventuelle d'adhésion du substrat sur le raidisseur, traitements intermédiaires éventuels, étape de recuit permettant la séparation). Par budget thermique, on entend que, pour une étape où un apport thermique est introduit (par exemple lors de l'étape de recuit), il ne faut pas raisonner uniquement sur la température mais sur le couple temps-température fourni au substrat.

Cette technique est maintenant utilisée pour la fabrication industrielle de substrats SOI (voir l'article de A.J. AUBERTON et al., intitulé "SOI materials for ULSI applications" paru dans Semiconductor International, 1995, vol. 11, pages 97-104). La faisabilité de cette technique aux matériaux semiconducteurs III-V tels que le GaAs a été récemment démontrée (voir l'article de E. JALAGUIER et al., intitulé "Transfer of 3 in GaAs film on silicon substrate by proton implantation process" publié dans Electronics Letters, 19 février 1998, vol. 34, n° 4, pages 408-409). Pour une telle structure, constituée d'une couche mince de GaAs sur un support en silicium, un collage par l'intermédiaire d'une couche d'oxyde de silicium a été utilisé. La couche mince de GaAs est donc isolée électriquement du support en silicium. Or, dans le cas d'une cellule solaire ainsi constituée, il est nécessaire d'établir une connexion électrique sur la face avant et une connexion électrique sur la face arrière, la liaison électrique avec la couche mince photovoltaïque se faisant au travers du substrat.

Une solution à ce problème peut être trouvée en choisissant une interface conductrice entre la couche mince et son support, cette interface devant aussi assurer l'adhésion des deux parties. Plusieurs techniques ont été proposées pour y parvenir. Elles sont présentées ci-dessous.

Il est possible d'obtenir un collage direct entre deux éléments semiconducteurs qui assure un bon contact électrique entre ces deux éléments. On peut se reporter à ce sujet aux articles suivants :
- "Electrical characteristics of directly-bonded GaAs and InP" de H. WADA et al., paru dans Appl. Phys. Lett., 62(7), 15 février 1993 ;
- "Low-resistance ohmic conduction across compound semiconductor wafer-bonded interfaces" de F.A. KISH et al., paru dans Appl. Phys. Lett., 67 (14), 2 octobre 1995.
Les techniques décrites dans ces articles sont cependant assez contraignantes. Elles exigent fréquemment une très bonne préparation des surfaces avant collage, souvent dans des conditions d'ultra-vide et/ou également des traitements thermiques de post-collage à haute température (de 600 à 1000°C) sous atmosphère réductrice d'hydrogène. Ces conditions sont difficiles à mettre en oeuvre, en particulier lorsque les deux matériaux semiconducteurs présentent une forte différence entre leurs coefficients de dilatation thermique (par exemple pour GaAs par rapport à Si ou SiC). Dans ce cas, un collage à basse température doit nécessairement être mis en oeuvre.

Une autre possibilité consiste à mettre en contact les deux éléments semiconducteurs par l'intermédiaire de couches métalliques préalablement déposées. Cette solution est décrite dans l'article "Low Température Bonding of Epitaxial Lift-Off Devices with AuSn "de G. RAINER DOHLE et al., paru dans IEEE Transactions on Components, Packaging, and Manufacturing Technology - Part B, vol. 19, n° 13, août 1996.

Par ailleurs, un développement du procédé décrit par le document FR-A-2 681 472, cité plus haut, a été divulgué dans le document FR-A-2 758 907. Ce dernier document divulgue que, sous certaines conditions, on peut utiliser une technique de masquage pour protéger des zones sensibles de la future couche mince (par exemple des zones constitutives de transistors MOS) du passage des ions destinés à créer les microcavités. Ceci implique une absence de microcavités dans les zones du substrat bombardé correspondant aux zones masquées. On peut malgré tout obtenir un clivage du substrat permettant d'en détacher un film mince si la largeur de chaque zone masquée ne dépasse pas une dimension limite déterminée pour le matériau constituant le substrat.

On pouvait donc penser, au vu de l'état de l'art annoncé ci-dessus, que le procédé de transfert d'une couche mince semiconductrice divulgué par le document FR-A-2 681 472 permettrait d'obtenir une couche mince de GaAs solidaire d'un support en silicium par l'intermédiaire d'une interface conductrice et qu'une liaison électrique serait possible entre la couche mince de GaAs et le support en silicium. Cependant, l'application de ce procédé de transfert a révélé le problème suivant. L'étape d'implantation ionique est généralement réalisée au moyen d'ions légers tels que des ions hydrogène. Il se trouve que le passage d'ions hydrogène dans du GaAs a pour effet de modifier considérablement la résistivité de la région bombardée par ces ions. Ainsi, une région de GaAs d'une résistivité initiale de l'ordre de 1 mΩ· cm voit, après bombardement par des ions hydrogène, sa résistivité atteindre une valeur de l'ordre de 10⁵ Ω · cm. Ce phénomène est dû à l'hydrogène qui crée des centres profonds dans le GaAs. Il en résulte qu'un film de GaAs épitaxié sur une couche mince de GaAs ainsi transféré sur un support en silicium serait isolé électriquement du support.

Pour pallier à ce problème, on peut penser utiliser d'autres espèces que l'hydrogène pour effectuer l'implantation ionique. L'hydrogène est cependant préféré pour des raisons pratiques. On peut aussi tenter de restituer une certaine conductivité à la couche mince de GaAs au moyen de recuits postérieurs au clivage. Cependant ces recuits impliquent une rupture dans le déroulement du procédé de fabrication et ne sont pas toujours souhaitables.

### Exposé de l'invention

Afin de remédier aux inconvénients de l'art antérieur, il est proposé une structure obtenue par le procédé décrit dans le document FR-A-2 681 472, ce procédé étant modifié pour que la couche conductrice ou semiconductrice à transférer, qui est une couche susceptible d'être altérée par le bombardement ionique, soit localement protégée. Cette protection permet d'obtenir une couche transférable présentant des zones à propriétés électriques non altérées.

L'invention a donc pour objet un procédé de fabrication d'une couche mince, la couche mince devant offrir au moins une liaison électrique verticale sur toute son épaisseur, la couche mince étant en un matériau choisi parmi SiC, GaAs et InP, le procédé comprenant les étapes suivantes :
- masquage d'une face d'un substrat comportant ledit matériau par des moyens de masquage définissant au moins une zone masquée dont la taille ne dépasse pas une dimension limite déterminée pour ledit matériau, cette dimension limite devant permettre le clivage du substrat lors de l'étape postérieure de clivage, les moyens de masquage arrêtant les espèces ioniques implantées au cours de l'étape d'implantation ionique ;
- implantation ionique du substrat au travers de sa face masquée au moyen desdites espèces choisies parmi l'hydrogène et/ou l'hélium, l'implantation étant apte à créer, dans le volume non masqué du substrat et à une profondeur voisine de la profondeur moyenne de pénétration des espèces, une couche de microcavités délimitant ladite couche mince, l'implantation étant également apte à rendre isolant ledit matériau implanté;
- retrait éventuel des moyens de masquage ;
- clivage du substrat au niveau de la couche de microcavités pour obtenir ladite couche mince, ladite couche mince présentant des zones isolantes au niveau des zones au travers desquelles l'implantation a été réalisée et des zones localisées verticales conductrices au niveau des zones protégées par masquage.

La face implantée du substrat peut être solidarisée avec un support avant l'étape de clivage. Elle peut aussi être solidarisée avec un support après l'étape de clivage.

L'étape de clivage correspond à une séparation entre la couche mince et le substrat.

Les moyens de masquage peuvent comprendre des plots d'un matériau capable d'empêcher la pénétration des ions dans le substrat lors de l'implantation ionique, ces plots étant déposés sur ladite face du substrat. Ils peuvent aussi comprendre des micro-éléments déposés sur ladite face du substrat. Ces micro-éléments peuvent être choisis parmi des microbilles et des particules.

Le masquage peut être réalisé de telle façon que la couche mince conserve globalement les propriétés électriques du substrat. Il peut aussi être réalisé de telle façon que la couche mince se présente globalement comme une couche isolante à l'exception d'au moins une partie formée d'une zone ou de plusieurs zones voisines conservant les propriétés électriques du substrat. Dans ce cas, la partie formée de cette zone ou de ces zones voisines conservant les propriétés électriques du substrat peut constituer une via conductrice ou une piste conductrice.

La solidarisation du substrat avec un support peut être réalisée par une méthode choisie entre le collage par adhésion moléculaire et le collage au moyen d'une brasure, par exemple une brasure à base d'indium.

Avant la solidarisation, le procédé peut comprendre une étape de préparation d'une interface conductrice entre ladite face du substrat et le support. Cette étape de préparation d'une interface conductrice peut comprendre le dépôt d'une couche métallique sur la face du substrat et/ou sur le support, par exemple le dépôt d'une couche de palladium. A cette couche métallique peut être associé le dépôt de matériaux conducteurs d'accrochage, par exemple des dépôts successifs de titane, de nickel et d'or. Un traitement thermique peut être effectué de manière à faire diffuser la couche métallique déposée. Le matériau métallique est choisi de préférence pour réagir avec au moins une partie du matériau du substrat et/ou du support.

Ce procédé s'applique à la fabrication d'une structure comportant une couche mince en SiC, en GaAs ou en InP sur un support, l'implantation ionique mettant en oeuvre des ions hydrogène et/ou hélium. Le support peut notamment être en silicium.

L'invention s'applique à l'obtention d'une structure comportant une couche mince, la couche mince étant une couche de matériau conducteur ou semiconducteur rendu isolant par implantation ionique à l'exception d'au moins une zone permettant une liaison électrique verticale sur toute l'épaisseur de la couche mince.

Selon une première variante, la couche mince comprend une multitude de zones, ces zones étant réparties sur toute la surface de la couche mince. Selon une seconde variante, la couche mince comprend une zone ou une pluralité de zones concentrées pour constituer au moins une via conductrice ou au moins une piste conductrice.

La couche mince peut être solidaire d'un support par l'intermédiaire d'une interface conductrice afin d'améliorer la liaison électrique entre ces deux éléments. Cette interface conductrice peut être constituée d'une couche métallique, par exemple d'une couche de palladium. A cette couche métallique peut être associé le dépôt de matériaux conducteurs d'accrochage, par exemple des dépôts successifs de titane, de nickel et d'or.

La couche mince peut aussi être solidaire d'un support par l'intermédiaire d'une brasure, par exemple une brasure à base d'indium.

Le support peut notamment être en silicium.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1 à 3 illustrent différentes étapes du procédé de fabrication selon la présente invention ;
- la figure 4 représente, vue en coupe transversale, une structure selon la présente invention, dans une application particulière,
- la figure 5 est une vue agrandie du détail repéré V sur la figure 4.

### Description détaillée d'un mode de réalisation de l'invention

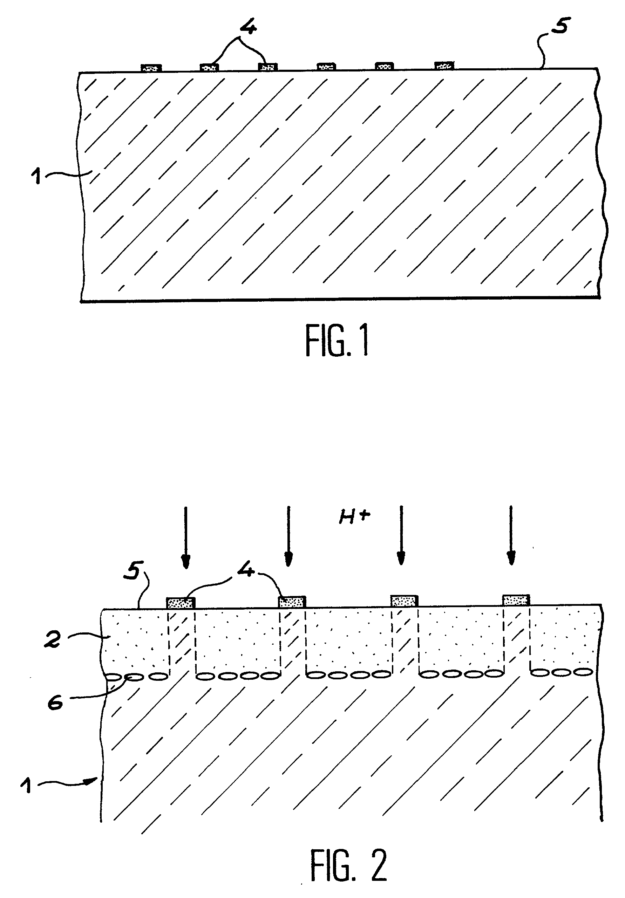

Les figures 1 à 3 sont des vues en coupe transversale. La figure 1 montre un substrat semiconducteur 1, par exemple un substrat en GaAs. Le substrat 1 est destiné à fournir la couche mince 2 d'une structure par solidarisation avec un support 3 par exemple en silicium (voir les figures 2 à 5).

Sur la face supérieure 5 du substrat 1, on dépose des plots 4 capables d'arrêter les ions qui seront ensuite implantés dans le volume du substrat au travers de la face 5. Les plots 4 peuvent être des plots de résine ou d'un autre matériau (oxyde, métal, etc.). L'épaisseur des plots est prévue pour empêcher les ions de pénétrer dans le substrat. La taille des plots est par exemple de l'ordre de 1 à 2 µm.

La figure 2 illustre l'étape d'implantation ionique. Des ions hydrogène sont par exemple utilisés pour bombarder le substrat 1 au travers de la face supérieure 5. L'énergie et la dose des ions sont choisies de façon à constituer une couche de microcavités 6 à une distance de la face 5 du substrat correspondant à l'épaisseur désirée pour la couche mince 2. Les ions hydrogène rendent, par leur passage, la couche mince 2 isolante. Cependant, les zones de la couche mince 2 masquées par les plots 4 ne sont pas altérées par les ions hydrogène. Ces zones masquées conservent donc les propriétés électriques initiales du substrat 1.

On entend par microcavité ou microbulle gazeuse toute cavité générée par l'implantation d'ions de gaz hydrogène et/ou de gaz rares dans le matériau. Les cavités peuvent se présenter sous forme très aplatie c'est-à-dire de faible hauteur, par exemple quelques distances inter-atomiques, aussi bien que sous forme sphérique ou sous tout autre forme différente de ces deux formes précédentes. Ces cavités peuvent contenir une phase gazeuse libre et/ou des atomes de gaz issus des ions implantés fixés sur des atomes du matériau formant les parois des cavités. Ces cavités sont généralement appelées en terminologie anglo-saxonne "platelets", "microblisters" ou même "bubbles".

On entend par couche de microcavités une zone contenant des microcavités pouvant être situées à différentes profondeurs et pouvant être adjacentes ou non entre elles.

On entend par espèces gazeuses des éléments par exemple d'hydrogène ou de gaz rares sous leur forme atomique (par exemple H) ou sous leur forme moléculaire par exemple H₂) ou sous leur forme ionique (par exemple H⁺, H²⁺) ou sous leur forme isotopique (par exemple deutérium) ou isotopique et ionique.

On entend par ailleurs, par implantation ionique, tout type d'introduction des espèces définies précédemment seules ou en combinaison telle que le bombardement ionique, la diffusion etc.

La couche 6 de microcavités ainsi obtenue est discontinue. Cependant, les discontinuités sont de petite taille (de l'ordre de 1 à 2 µm) et ne sont pas susceptibles de modifier le phénomène de propagation des fissures lors de l'étape postérieure de clivage.

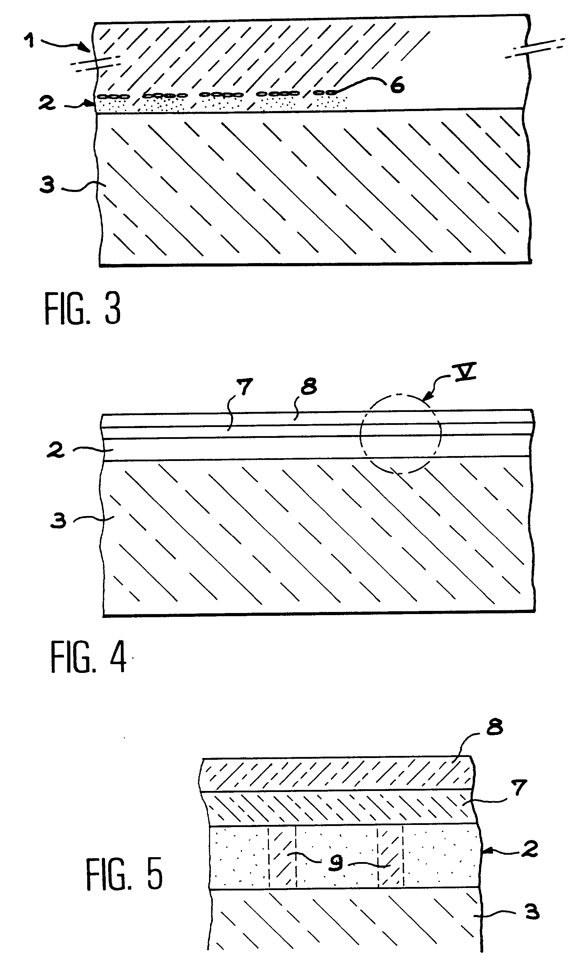

Après l'étape d'implantation ionique, les plots 4 déposés par la face 5 du substrat 1 sont éliminés. La face 5 du substrat 1 peut être rendue solidaire, par exemple par adhésion moléculaire, d'une face de réception du support 3 (voir la figure 3). Avant cette étape de solidarisation, les faces à réunir sont préparées pour constituer une interface de collage. A titre d'exemple, un contact ohmique de très faible résistivité (1 Ω · cm) peut être obtenu si l'on réalise l'adhésion par l'intermédiaire d'une couche de palladium déposée sur l'une des faces ou sur les deux faces à réunir. Un résultat similaire peut être obtenu dans le cas d'une brasure à base d'indium.

Le traitement thermique conduit, quel que soit le type de matériau solide, à la coalescence des microcavités qui amène une fragilisation de la structure au niveau de la couche de microcavités. Cette fragilisation permet la séparation du matériau sous l'effet de contraintes internes et/ou de pression dans les microcavités, la séparation pouvant être naturelle ou assistée par application de contraintes externes.

Ainsi, le clivage du substrat 1 le long de la couche de microcavités 6 est obtenu par exemple uniquement à la suite d'un traitement thermique approprié ou en combinant un traitement thermique et des forces mécaniques par exemple de traction et/ou de cisaillement et/ou de flexion ou encore par l'utilisation uniquement de forces mécaniques. Les forces mécaniques peuvent être appliquées perpendiculairement aux plans des couches et/ou parallèlement à celles-ci. Elles peuvent être localisées en un point ou une zone ou être appliquées à différents endroits de façon symétrique ou dissymétrique. Le clivage procure une structure comportant la couche mince 2 solidarisée du support 3 ou une couche mince autoportée lorsque la couche mince n'est pas solidarisée avec le support.

La face libre de la couche mince 2 peut ensuite subir une opération de polissage mécano-chimique. Par épitaxie, on peut alors déposer successivement sur la couche mince 2 des couches 7 et 8 du même matériau semiconducteur que la couche mince 2. Une cellule solaire peut ainsi être constituée en déposant une couche 7 dopée n et une couche 8 dopée p. Comme le montre la figure 5, l'ensemble constitué par les couches 7 et 8 est relié électriquement au support 3 par des zones 9 qui ont par exemple 1 µm de côté. Si les zones 9 sont constituées d'un matériau de résistivité 1 Ω · cm, la résistance d'une zone 9, pour une couche mince 2 d'épaisseur 100 nm, est de 1000 Ω. Si les zones 9 sont espacées chacune de 10 µm, la densité totale de ces zones est de l'ordre de 10⁶/cm², ce qui correspond à une résistance totale apparente de 0,001 Ω pour une surface de 1 cm² de couche mince. Si la surface de couche mince est par exemple de 70 cm², sa résistance dans le sens vertical est alors de l'ordre de 10⁻⁵ Ω. Si une telle cellule solaire reçoit une puissance de 1 kW/m², la puissance récupérable, pour un rendement de 20%, est de 200 W/m². Pour une tension de 1 volt, cela équivaut à 200 A/m² soit un courant de 1,4 A pour une structure de 70 cm². La résistance de cette structure entraîne alors une chute de tension de 10⁻⁵ V, soit une perte absolument négligeable.

Etant donné que les dimensions des zones de masquage sont petites et que le positionnement exact des plots de masquage n'est pas important, ce masquage peut être réalisé par des moyens très simples, sans lithographie. Ces moyens sont par exemple un masquage par microbilles déposées sur la face 5 du substrat 1 avant l'étape d'implantation ionique. Ces microbilles, ou d'autres particules, peuvent être en verre, en quartz ou en un autre matériau approprié. Leur taille varie de quelques dixièmes de µm à quelques µm.

Selon les applications, la couche mince 2 peut être hétérogène, c'est-à-dire composée de matériaux de nature différente empilés les uns sur les autres et/ou alignés les uns à côté des autres.

Par ailleurs, la couche mince peut être autoportée lorsque son épaisseur, compte tenu de la nature du matériau la réalisant, lui assure une rigidité suffisante pour induire la séparation. Cette couche mince autoportée permet des applications par exemple du type de celles des films conducteurs anisotropes.

Pour obtenir une épaisseur de la couche mince apte à lui assurer cette rigidité suffisante, on peut jouer sur la profondeur d'implantation des espèces et/ou sur la formation d'une épaisseur complémentaire de matériau, par exemple par épitaxie ou par hétéro-épitaxie à la surface de la couche mince ou par un dépôt.

En outre, selon l'invention, l'implantation peut résulter d'espèces différentes, implantées simultanément ou successivement (cf. FR-A-2 773 261).

## Revendications

1. Procédé de fabrication d'une couche mince (2), la couche mince (2) devant offrir au moins une liaison électrique verticale sur toute son épaisseur, la couche mince (2) étant en un matériau choisi parmi SiC, GaAs et InP, le procédé comprenant les étapes suivantes :
- masquage d'une face (5) d'un substrat (1) comportant ledit matériau par des moyens de masquage (4) définissant au moins une zone masquée dont la taille ne dépasse pas une dimension limite déterminée pour ledit matériau, cette dimension limite devant permettre le clivage du substrat (1) lors de l'étape postérieure de clivage, les moyens de masquage arrêtant les espèces ioniques implantées au cours de l'étape d'implantation ionique ;
- implantation ionique du substrat (1) au travers de sa face masquée au moyen desdites espèces choisies parmi l'hydrogène et/ou l'hélium, l'implantation étant apte à créer, dans le volume non masqué du substrat (1) et à une profondeur voisine de la profondeur moyenne de pénétration des espèces, une couche de microcavités (6) délimitant ladite couche mince (2), l'implantation étant également apte à rendre isolant ledit matériau implanté ;
- retrait éventuel des moyens de masquage (4) ;
- clivage du substrat (1) au niveau de la couche de microcavités (6) pour obtenir ladite couche mince, ladite couche mince présentant des zones isolantes au niveau des zones au travers desquelles l'implantation a été réalisée et des zones localisées verticales qui conservent les propriétés électriques initiales du substrat (1) au niveau des zones protégées par masquage.

2. Procédé selon la revendication 1, **caractérisé en ce que** la face implantée (5) du substrat (1) est solidarisée avec un support (3) avant l'étape de clivage.

3. Procédé selon la revendication 1, **caractérisé en ce que** la couche mince est solidarisée avec un support après l'étape de clivage.

4. Procédé selon l'une quelconque des revendications 1 à 3, **caractérisé en ce que** les moyens de masquage (4) comprennent des plots d'un matériau capable d'empêcher la pénétration des ions dans le substrat lors de l'implantation ionique, ces plots (4) étant déposés sur ladite face (5) du substrat (1).

5. Procédé selon la revendication 1, **caractérisé en ce que** les moyens de masquage comprennent des micro-éléments déposés sur ladite face du substrat.

6. Procédé selon la revendication 5, **caractérisé en ce que** lesdits micro-éléments sont choisis parmi des microbilles et des particules.

7. Procédé selon l'une quelconque des revendications 1 à 6, **caractérisé en ce que** le masquage est réalisé de telle façon que la couche mince (2) conserve globalement les propriétés électriques du substrat (1).

8. Procédé selon l'une quelconque des revendications 1 à 6, **caractérisé en ce que** le masquage est réalisé de telle façon que la couche mince (2) se présente globalement comme une couche isolante à l'exception d'au moins une partie formée d'une zone ou de plusieurs zones voisines conservant les propriétés électriques du substrat (1).

9. Procédé selon la revendication 8, **caractérisé en ce que** la partie formée de cette zone ou de plusieurs zones voisines conservant les propriétés électriques du substrat (1) constitue une via conductrice ou une piste conductrice.

10. Procédé selon la revendication 2, **caractérisé en ce que** l'étape de solidarisation du substrat avec Je support est réalisée par une méthode choisie entre le collage par adhésion moléculaire et le collage au moyen d'une brasure.

11. Procédé selon la revendication 10, **caractérisé en ce que** ladite brasure est à base d'indium.

12. Procédé selon la revendication 2, **caractérisé en ce qu'**il comprend, avant l'étape de solidarisation, une étape de préparation d'une interface conductrice entre ladite face (5) du substrat (1) et ledit support (3).

13. Procédé selon la revendication 12, **caractérisé en ce que** l'étape de préparation d'une interface conductrice comprend le dépôt d'une couche métallique sur ladite face (5) du substrat (1) et/ou sur le support (3).

14. Procédé selon la revendication 13, **caractérisé en ce que** ladite couche métallique est une couche de palladium.

15. Procédé selon l'une des revendications 13 ou 14, **caractérisé en ce qu'**à ladite couche métallique d'interface est associé le dépôt de matériaux conducteurs d'accrochage.

16. Procédé selon la revendication 15, **caractérisé en ce que** les matériaux conducteurs d'accrochage sont des dépôts successifs de titane, de nickel et d'or.

17. Procédé selon l'une quelconque des revendications 13 à 16, **caractérisé en ce qu'**un traitement thermique est effectué de manière à faire diffuser la couche métallique déposée.

18. Procédé selon l'une quelconque des revendications 1 à 17 où la couche mince en SiC, GaAs ou en InP est sur un support.

19. Procédé selon la revendication 18, **caractérisé en ce que** le support est en silicium.

## Patentansprüche

1. Verfahren zur Herstellung einer dünnen Schicht (2), wobei die dünne Schicht (2) wenigstens eine senkrechte elektrische Verbindung über ihre gesamte Dicke bieten soll, wobei die dünne Schicht (2) aus einem Material hergestellt ist, das aus SiC, GaAs und InP ausgewählt ist, wobei das Verfahren die folgenden Schritte umfasst:
- Maskieren einer Fläche (5) eines Substrats (1), das das Material umfasst, durch Maskierungsmittel (4), die wenigstens eine maskierte Zone definieren, deren Größe eine bestimmte Grenzabmessung für das Material nicht übersteigt, wobei diese Grenzabmessung das Spalten des Substrats (1) während des späteren Spaltungsschritts erlauben soll, wobei die Maskierungsmittel im Verlauf des Schritts der Ionenimplantation implantierte Ionenspezies stoppen;
- Ionenimplantation des Substrats (1) durch seine maskierte Fläche hindurch mittels der Spezies ausgewählt aus Wasserstoff und/oder Helium, wobei die Implantation dazu ausgelegt ist, in dem nicht maskierten Volumen des Substrats (1) und bei einer Tiefe nahe der mittleren Eindringtiefe der Spezies eine Schicht von Mikrokavitäten (6) zu erzeugen, die die dünne Schicht (2) begrenzt, wobei die Implantation ferner dazu ausgelegt ist, das implantierte Material isolierend zu machen;
- gegebenenfalls Entfernen der Maskierungsmittel (4);
- Spalten des Substrats (1) im Bereich der Schicht von Mikrokavitäten (6), um die dünne Schicht zu erhalten, wobei die dünne Schicht isolierende Zonen im Bereich der Zonen aufweist, durch die hindurch die Implantation realisiert worden ist, sowie lokalisierte senkrechte Zonen, die die anfänglichen elektrischen Eigenschaften des Substrats (1) beibehalten, im Bereich der durch Maskierung geschützten Zonen.

2. Verfahren nach Anspruch 1, **dadurch gekennzeichnet, dass** die implantierte Fläche (5) des Substrats (1) vor dem Schritt des Spaltens mit einem Träger (3) verbunden wird.

3. Verfahren nach Anspruch 1, **dadurch gekennzeichnet, dass** die dünne Schicht nach dem Schritt des Spaltens mit einem Träger verbunden wird.

4. Verfahren nach einem der Ansprüche 1 bis 3, **dadurch gekennzeichnet, dass** die Maskierungsmittel (4) Punkte aus einem Material umfassen, das dazu ausgelegt ist, das Eindringen der Ionen in das Substrat während der Ionenimplantation zu verhindern, wobei diese Punkte (4) auf der Fläche (5) des Substrats (1) aufgebracht sind.

5. Verfahren nach Anspruch 1, **dadurch gekennzeichnet, dass** die Maskierungsmittel Mikroelemente umfassen, die auf der Fläche des Substrats aufgebracht sind.

6. Verfahren nach Anspruch 5, **dadurch gekennzeichnet, dass** die Mikroelemente ausgewählt sind aus Mikrokügelchen und Partikeln.

7. Verfahren nach einem der Ansprüche 1 bis 6, **dadurch gekennzeichnet, dass** die Maskierung derart realisiert wird, dass die dünne Schicht (2) im Allgemeinen die elektrischen Eigenschaften des Substrats (1) beibehält.

8. Verfahren nach einem der Ansprüche 1 bis 6, **dadurch gekennzeichnet, dass** die Maskierung derart realisiert wird, dass die dünne Schicht (2) im Allgemeinen eine isolierende Schicht ist, außer in wenigstens einem Teil, der gebildet ist durch eine Zone oder durch mehrere benachbarte Zonen, die die elektrischen Eigenschaften des Substrats (1) beibehalten.

9. Verfahren nach Anspruch 8, **dadurch gekennzeichnet, dass** der Teil, der durch diese Zone oder durch mehrere benachbarte Zonen gebildet ist, die die elektrischen Eigenschaften des Substrats (1) beibehalten, einen leitenden Durchgang oder eine leitende Bahn bildet.

10. Verfahren nach Anspruch 2, **dadurch gekennzeichnet, dass** der Schritt des Verbindens des Substrats mit dem Träger durch ein Verfahren realisiert wird, ausgewählt aus dem Kleben durch molekulare Adhäsion und dem Kleben mittels Lötung.

11. Verfahren nach Anspruch 10, **dadurch gekennzeichnet, dass** die Lötung auf Basis von Indium ist.

12. Verfahren nach Anspruch 2, **dadurch gekennzeichnet, dass** es vor dem Schritt des Verbindens einen Schritt des Herstellens einer leitenden Grenzfläche zwischen der Fläche (5) des Substrats (1) und dem Träger (3) umfasst.

13. Verfahren nach Anspruch 12, **dadurch gekennzeichnet, dass** der Schritt des Herstellens einer leitenden Grenzfläche das Aufbringen einer metallischen Schicht auf der Fläche (5) des Substrats (1) und/oder auf dem Träger (3) umfasst.

14. Verfahren nach Anspruch 13, **dadurch gekennzeichnet, dass** die metallische Schicht eine Palladiumschicht ist.

15. Verfahren nach einem der Ansprüche 13 oder 14, **dadurch gekennzeichnet, dass** der metallischen Grenzflächenschicht die Aufbringung von leitenden Ankopplungsmaterialien zugeordnet ist.

16. Verfahren nach Anspruch 15, **dadurch gekennzeichnet, dass** die leitenden Ankopplungsmaterialien aufeinanderfolgende Aufbringungen von Titan, von Nickel und von Gold sind.

17. Verfahren nach einem der Ansprüche 13 bis 16, **dadurch gekennzeichnet, dass** eine thermische Behandlung derart durchgeführt wird, dass die aufgebrachte metallische Schicht diffundiert.

18. Verfahren nach einem der Ansprüche 1 bis 17, wobei die dünne Schicht aus SiC, GaAs oder aus InP auf einem Träger ist.

19. Verfahren nach Anspruch 18, **dadurch gekennzeichnet, dass** der Träger aus Silicium ist.

## Claims

1. Method of manufacturing a thin layer (2), the thin layer (2) having to provide at least one vertical electrical connection through its entire thickness, the thin layer (2) being made in a material chosen amongst SiC, GaAs and InP, the method comprising the following steps :
- masking one face (5) of a substrate (1) comprising said material by masking means (4) that define at least one masked area, the size of which does not exceed a limiting dimension specified for said material, this limiting dimension having to allow cleavage of the substrate (1) at the time of the subsequent cleavage step, the masking means stopping the ionic species implanted during the ion implantation step;
- ion implantation of the substrate (1) through its masked face by means of said species chosen amongst hydrogen and/or helium, the implantation being capable of creating, within the non-masked volume of the substrate (1) and at a depth close to the mean depth of penetration of the species, a layer of micro-cavities (6) demarcating said thin layer (2), the implantation being also capable to make said implanted material insulating;
- possible removal of the masking means (4);
- cleavage of the substrate (1) at the level of the layer of micro-cavities (6) in order to obtain said thin layer, said thin layer having insulating zones at the level of zones through which the implantation was made and localized vertical zones that retain the electrical properties of the substrate at the level of the zones protected by the masking.

2. Method according to Claim 1, **characterized in that** the implanted face (5) of the substrate (1) is made integral with a support (3) before the cleavage step.

3. Method according to Claim 1, **characterized in that** the thin layer is made integral with a support after the cleavage step.

4. Method according to any one of Claims 1 to 3, **characterized in that** the masking means (4) comprise deposits of a material capable of preventing penetration of the ions into the substrate during the ion implantation, these deposits (4) being deposited on said face (5) of the substrate (1).

5. Method according to Claim 1, **characterized in that** the masking means comprise micro-elements deposited on said face of the substrate.

6. Method according to Claim 5, **characterized in that** said micro-elements are chosen from among microbeads and particles.

7. Method according to any one of Claims 1 to 6, **characterized in that** the masking is carried out in such a way that the thin layer (2) overall preserves the electrical properties of the substrate (1).

8. Method according to any one of Claims 1 to 6, **characterized in that** the masking is carried out in such a way that the thin layer (2) overall behaves like an insulating layer except for at least one part formed from one zone or from several neighboring zones preserving the electrical properties of the substrate (1).

9. Method according to Claim 8, **characterized in that** the part formed from this zone or from several neighboring zones preserving the electrical properties of the substrate (1) constitutes a conductive via or a conductive track.

10. Method according to Claim 2, **characterized in that** the step of making the substrate integral with the support is carried out by a method chosen between bonding by molecular adhesion and bonding by means of a brazing material.

11. Method according to Claim 10, **characterized in that** said brazing material is based on indium.

12. Method according to Claim 2, **characterized in that** it includes, before the step of making integral, a step of preparing a conductive interface between said face (5) of the substrate (1) and said support (3).

13. Method according to Claim 12, **characterized in that** the step of preparing a conductive interface comprises the deposition of a metal layer onto said face (5) of the substrate (1) and/or onto the support (3).

14. Method according to Claim 13, **characterized in that** the said metal layer is a layer of palladium.

15. Method according to one of Claims 13 or 14, **characterized in that** said interface metal layer is associated with the deposition of conductive metal bonding materials.

16. Method according to Claim 15, **characterized in that** the conductive bonding materials are successive deposits of titanium, nickel and gold.

17. Method according to any one of Claims 13 to 16, **characterized in that** a heat treatment is carried out in a way that causes diffusion of the deposited metal layer.

18. Method according to any one of Claims 1 to 17 wherein the thin layer of SiC, GaAs or InP is on a support.

19. Method according to any one of Claims 1 to 18, **characterized in that** the support is made of silicon.
